(19) Europäisches Patentamt
European Patent Office
Office européen des brevets

(11) Publication number : **0 449 439 A1**

# (12) EUROPEAN PATENT APPLICATION

(21) Application number : **91301866.9**

(51) Int. Cl.$^5$ : **G03F 7/11**

(22) Date of filing : **06.03.91**

(30) Priority : **13.03.90 JP 61555/90**

(43) Date of publication of application : **02.10.91 Bulletin 91/40**

(84) Designated Contracting States : **DE FR GB**

(71) Applicant : **FUJITSU LIMITED**
**1015, Kamikodanaka Nakahara-ku**
**Kawasaki-shi Kanagawa 211 (JP)**

(72) Inventor : **Nakamura, Yuko**
**Shiraiso 2F, 1644, Kamikodanaka**
**Nakahara-ku, Kawasaki-shi, Kanagawa 211 (JP)**
Inventor : **Motoyama, Takushi**
**9-12, Shimoodanaka 1-chome**
**Nakahara-ku, Kawasaki-shi, Kanagawa 211 (JP)**

(74) Representative : **Perry, Robert Edward et al**
**GILL JENNINGS & EVERY 53-64 Chancery Lane**
**London WC2A 1HN (GB)**

(54) **Process for formation of resist patterns.**

(57) A process for the formation of fine resist patterns, in which an electron beam-sensitive resist layer is used in combination with a layer of electron beam-insensitive, electrically discharging polymer adjacent thereto, the polymer being selected from the group consisting of diene polymers, acetylene polymers and alkylstyrene polymers. Preferably, the polymer layer is used as an overcoat layer for a single layer electron beam resist or as a bottom layer resist for a bi-level resist system, to effectively prevent a "charge-up" of the resist layer due to the electron beam exposure. According to the present process, fine resist patterns can be obtained with a high reproducivility without the use of a complicated process. In addition, since it has no electrical conductivity, the polymer used in the present process can be stably stored for an exended period.

EP 0 449 439 A1

# PROCESS FOR FORMATION OF RESIST PATTERNS

## BACKGROUND OF THE INVENTION

### 1. Field of the Invention

The present invention relates to an electron beam lithography, more particularly, to a process for the formation of fine electron beam resist patterns using the polymer having an electrical discharge function. The present invention can be advantageously utilized in the production of semiconductor devices such as large-scale integrated (LSI) circuits, very-large-scale integrated (VLSI) circuits, and bubble memory devices.

### 2. Description of the Related Art

Currently, in view of the high degree of density and integration required for elements in the production of LSIs, VLSIs and other semiconductor devices, an electron beam (EB) lithography in which an electron beam is used as an exposure source in place of other conventional exposure sources such as ultraviolet (UV) radiation, is now widely used in the production of semiconductor devices or other devices. This is because the EB lithography enables the forming of fine submicron resist patterns due to the significantly shortened wavelength of the electron beam.

In the EB lithography, a surface of the resist layer is sequentially scanned with an electron beam in accordance with a predetermined pattern of images to be recorded. Unfortunately, during the EB scanning or patterning, a site to be newly scanned is adversely affected by an electrical charge accumulated in the exposed sites adjacent thereto. Such an accumulation of the electrical charge in the resist layer is referred to herein as a "charge up" of the resist. Namely, since the exposed site has been electrically charged by the EB process, an electrical field created thereby has an affect on the course of the scanning beam directed to an adjacent new site. More particularly, the scanning beam is affected by the electrical field and is distorted, and thus an exposure pattern of the beam recorded as a latent image in the resist layer is misaligned or shifted, or sometimes the pattern itself is omitted. The "charge up" problem of the resist layer is practically unavoidable, and furthermore, it can be accelerated with an increase of the thickness of the resist layer. Obviously, the semiconductor device material having a misaligned resist pattern must be discarded to avoid a production of commercially unacceptable devices, which lowers the yield and increases the production costs. Therefore, there arose an urgent need for an improved EB lithography not causing the above-described "charge up" problem.

When the EB lithography is used in the formation of multilayer wiring in the semiconductor devices or other devices, it is essential to solve another problem caused due to the steps or topographic features of the substrate. Namely, although the multilayer wiring is intended to increase a degree of integration of the circuits in the resulting devices, it produces steps having a height of 0.5 to 1 μm on a surface of the substrate. To solve the problem due to the stepped portions on the substrate surface, an attempt was made to increase a thickness of the resist layer for the single layer resist system, but as previously mentioned, this accelerated the accumulation of the electrical charge in the resist layer.

Another proposed means of solving the problem of the stepped portions on the substrate surface was that of using a bi-level resist system. According to the bi-level resist system, stepped portions on the substrate surface are brought to the planariazation of the first bottom layer resist. After this planarizing of the stepped portions, a top layer resist having an EB sensitivity and resistance to dry etching is applied at a reduced layer thickness over the bottom layer resist, the top layer resist is then EB-exposed and developed, and the resulting patterns of the top layer resist are transferred to the bottom layer resist by a dry etching process. This process enables satisfactory fine resist patterns to be produced on the stepped substrate surface. As clear from the above description, there is a need for the provision of an improved EB lithography which can be advantageously applied to both the single layer resist system and the bi-level resist system, without "charge up" problem of the EB resist layer.

Since the "charge up" problem of the EB resist layer is very important, numerous patent publications have already discussed this problem, and teach that it can be solved by using an electrically conductive layer or coating, as such a layer or coating will effectively discharge or dissipate any electrical charge accumulated in the resist layer. Further, these publications teach that such an electrically conductive layer can be formed by any conventional film formation method, including, for example, a vacuum deposition of metals such as Al or Pt or electrically conductive inorganic materials such as $In_2O_3$, or a coating of a polymeric material containing metals, electrically conductive inorganic materials, carbon (C), surface-active agents, charge transfer agents or complexes, such as TCNQ (tetracyanoquinodimethane) complex, or related materials dispersed as a filler therein.

Typical examples of the patent publications teaching the above technologies are those shown as follows:

(1) Japanese Unexamined Patent Publication (Kokai) No. 54-43681
(2) Japanese Kokai No. 54-116883
(3) Japanese Kokai No. 56-114323
(4) Japanese Kokai No. 56-125833
(5) Japanese Kokai No. 56-125834
(6) Japanese Kokai No. 58-54633
(7) Japanese Kokai No. 58-136029
(8) Japanese Kokai No. 59-93441
(9) Japanese Kokai 59-104126
(10) Japanese Kokai No. 59-132124
(11) Japanese Kokai No. 63-181428
(12) Japanese Kokai No. 63-204724
(13) Japanese Kokai No. 63-254728
(14) Japanese Kokai No. 63-254729

Nevertheless, problems arise in the formation of the conductive layer suggested in each of these Japanese Kokai's, since a vacuum deposition or sputtering method requires additional steps and a specific device, and thus it is preferable to avoid the use of such a method and to further simplify the formation process. Further, when the polymeric material having a conductive filler such as metal or conductive inorganic materials dispersed therein is used in the formation of the conductive layer, the resultant layer suffers from an insufficient layer formation and poor properties of the layer. For example, small particles of the dispersed conductive material can remain on a surface of the resist layer and hinder the formation of an accurate and fine resist pattern. Furthermore, when the surface-active agents or charge transfer agents are used as the conductive material, a remarkable reduction of the electrical discharge function thereof occurs, because the discharge function is notably reduced by various factors such as aging or environmental conditions, for example, temperature, oxygen and humidity. In addition, a charge transfer complex polymer, such as the TCNQ complex polymer, as a conductive layer suffers from a reduced storage stability, because the properties of such complex polymer can be changed with a lapse of time (about one week to 2 or 3 months) due to atmospheric conditions such as the presence of oxygen or humidity.

The present inventors, as disclosed in U. S. Patent Application Serial No. 420,427 filed on October 12, 1989, found that the "charge up" problem of the EB resist layer can be solved by using a conductive layer comprising a specific, conducting or semiconducting polymer or a non-conducting precursor thereof and a photo-acid generator sensitive to an ultraviolet radiation exposure, in combination with an EB resist layer positioned in adjacent to the conductive layer. According to this invention, an electrical conductive layer not suffering from an accumulation of the electrical charge in the resist layer during the EB exposure can be produced with a high reliability, and therefore, fine EB resist patterns can be produced with a high reproducibility. Nevertheless, since the conductive layer used in this invention contains a photo-acid generator, it is necessary to expose the conductive layer to the UV radiation to cause an increase of the conductivity of the polymer thereof. Therefore, to shorten the pattern formation process, the provision of an improved EB lighography having no preexposure step is desired.

## SUMMARY OF THE INVENTION

Accordingly, an object of the present invention is to provide a process for the formation of EB resist pattern on a substrate having topographic features, i.e., a stepped substrate, which process can solve the problems of the above-described prior art.

Since the prior art processes are yet to be completed, the object of the present invention is to provide an improved pattern formation process which enables the conducting of an EB resist patterning at a high reproducibility and accuracy, without the use of complicated processes and devices. The process can be advantageously applied to both the single layer resist system and the bi-level resist system. Further, the electrically discharging material used in the present process exhibits a high storage stability.

The inventors found that, if an electron beam-sensitive resist layer is used in combination with a layer of the electron beam-insensitive polymer adjacent thereto, the polymer being selected from the group consisting of diene polymers, acetylene polymers and alkylstyrene polymers, the above-described objects of the present invention can be attained.

According to the present invention, there is provided a process for the formation of resist patterns which comprises the steps of:

forming a layer of an electron beam-sensitive resist on the substrate, with the proviso that, before or after

the formation of this layer, an electron beam-insensitive polymer selected from the group consisting of diene polymers, acetylene polymers and alkylstyrene polymers is applied to the substrate to form a combination of the electron beam-sensitive resist layer and the electrically discharging polymer layer adjacent thereto;

pattern-wise exposing the electron beam-sensitive resist layer to an electron beam; and

developing the pattern-wise exposed resist layer to selectively remove the exposed or unexposed area of the resist layer.

The substrate used herein is not restricted, and therefore any conventional substrate materials can be used herein. The substrate, in some instances, may has topographic features (stepped portions) on a surface thereof because of the presence of a multilayer wiring or other means fabricated thereon. The term "substrate" used herein is intended to refer to the substrate itself or to the electrically conductive layer, electrically insulating layer or other thin layer(s) including wiring formed on the substrate. Of course, the substrate itself may be formed of any conventional materials, such as a glass substrate or semiconductor substrate (for example, silicon or SOI, i.e., silicon-on-insulator).

After the thorough study, the inventors found that certain types of polymers can be used for the electrical discharge layer adjacent to the electron beam-sensitive resist layer. It is considered, but not concluded, that the electrically discharging polymers useful in the present invention can cause a charge transfer upon exposure to an electron beam. Namely, radicals are generated upon EB exposure, and the thus generated radicals can cause a charge transfer, or upon EB exposure, the exposed polymer material exhibits a charge transfer property. Suitable polymers include, for example, poly 3,4-diphenylbutadiene, poly chloroprene, poly phenylacetylene, poly chlorophenylacetylene and poly α-methylstyrene. Each of these polymers has an electrical conductivity of about $10^{-16}\,\Omega^{-1}\,cm^{-1}$ because it is an electrically insulating material, but can exhibit a good discharge layer upon exposure to EB. In addition, it is noted that these electrically discharging polymers are very stable in contrast to the conventional electrically conducting polymers.

When the pattern formation process of the present invention is applied to a single layer resist system, the elecrtrically discharging polymer layer is formed as an overcoat layer over the electron beam-sensitive resist layer of a single layer structure. In this case, the pattern formation process comprises the steps of:

forming a layer of the electron beam-sensitive resist on the substrate;

further forming a layer of the electrically discharging polymer over the electron beam-sensitive resist layer,

pattern-wise exposing the electron beam-sensitive resist layer through the electrically discharging polymer layer to the electron beam; and

developing the exposed resist layer with a developer.

When the pattern formation process is applied to a bi-level resist system, the electrically discharging polymer layer is used as a bottom layer resist in a bi-level resist structure. In this case, the pattern formation process comprises the steps of:

forming a layer of the electrically discharging polymer as a bottom layer resist on the substrate;

further forming a layer of the electron beam-sensitive resist as a top layer resist, over the electrically discharging polymer layer;

pattern-wise exposing the electron beam-sensitive resist layer to the electron beam;

developing the exposed resist layer with a developer; and

dry etching the electrically discharging polymer layer through the developed resist layer as a mask to thereby transfer a pattern of the resist layer to the electrically discharging polymer layer.

The pattern formation process is preferably used in the production of semiconductor devices, and during such use, the substrate can be etched, using the patterned resist layer as a mask, to form a part of the semiconductor devices.

## BRIEF DESCRIPTION OF THE DRAWINGS

Figures 1A to 1D are cross-sectional views showing, in sequence, the resist process of the single layer resist system according to the present invention; and,

Figs. 2A to 2F are cross-sectional views showing, in sequence, the resist process of the bi-level resist system according to the present invention.

## DESCRIPTION OF THE PREFERRED EMBODIMENTS

The electrically discharging polymer of the present invention is preferably used as a thin layer, having a thickness of about 500 Å, over the single layer resist having a thickness of about 1 to 1.5 μm. Any conventional positive-working or negative-working, EB-sensitive resist materials can be used to form the single layer resist,

and typical examples of such resist materials include "ZCMR-100" (trade name of Nihon Zeon Co.), "CMS-EX" (trade name of Tosoh Co.), "EBR-9" (trade name of Toray Co.), and "OEBR-1000" (trade name of Tokyo Ohka Co.). In this instance, during an EB exposure of the EB resist layer, most of the applied electrons are reflected at a surface of the substrate, but some are accumulated on the substrate surface, thereby causing the charge up of the resist layer. Nevertheless, since the resist layer has an overcoat layer of the described electrically discharging polymer, the electrical charge accumulated in the resist layer can be effectively discharged.

Similarly, the electrically discharging polymer of the present invention is preferably used as a bottom layer resist of the bi-level resist system. For example, to planarize the topographic features of the substrate surface, the polymer of the present invention as the bottom layer resist is preferably applied at a thickness of about 1 to 3 μm, and the EB-sensitive resist material as the top layer resist is preferably applied at a thickness of about 1000 to 2000 Å. As in the above-described single layer resist system, any conventional positive-working or negative-working EB-sensitive resist materials can be used to form the top layer resist. In this instance, electrons applied to the resist layer during the EB exposure pass through the resist layer and are then reflected at the substrate surface, to thereby cause the charge up of the thick bottom layer. Nevertheless, since the bottom layer is made of the electrically discharging polymer of the present invention, it is possible to effectively discharge the electrical charge accumulated therein.

Suitable polymers useful as an electrically discharging layer adjacent to the EB resist layer have been already mentioned, but more particularly suitable diene polymers are represented by the following formula

(I):

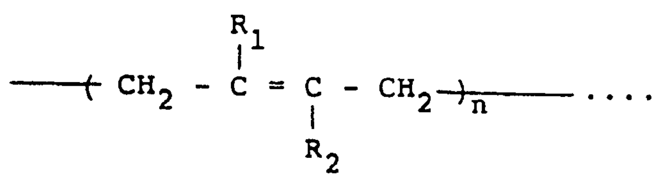
(I)

in which $R_1$ and $R_2$ each represent a hydrogen atom, a substituted or unsabstituted phenyl group or a halogen atom, and n is an integer.

Further, suitable acetylen polymers are represented by the following formula (II):

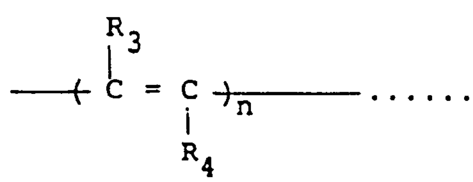
(II)

in which $R_3$ and $R_4$ each represent a hydrogen atom, a substituted or unsubstituted phenyl group or a halogen atom, and n is an integer.

Furthermore, suitable alkyl-styrene polymers are represented by the following formula (III):

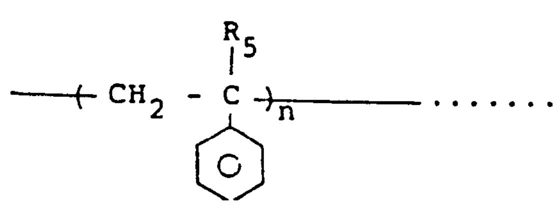
(III)

in which $R_5$ represents a lower alkyl group, and n is an integer.

In the diene polymers of the formula (I), when $R_1$ and $R_2$ each represent a phenyl group, poly 3,4-diphenyl butadiene is used as the polymer, and when $R_1$ represents a hydrogen atom and $R_2$ represents a chlorine atom, poly chloroprene is used as the polymer. In the acetylene polymers of the formula (II), when $R_3$ is H and $R_4$ is phenyl, poly phenylacetylene is used as the polymer, and when $R_3$ is Cl and $R_4$ is phenyl, poly chlorophenylacetylene is used as the polymer. The alkylstyrene polymer of the formula (III), in which $R_5$ is methyl, is poly α-methylstyrene.

The pattern formation process of the present invention will be further described with reference to the accompanying drawings (Figs. 1A to 1D, and Figs. 2A to 2F) illustrating two preferred embodiments of the present invention. Note, although the use of the negative-working EB resist is described in Figs. 1A to 1D and Figs. 2A to 2F, positive-working EB resists can be also used in the process of the present invention, with satisfactory results.

The pattern formation process using the single layer resist process can be carried out, for example, as shown in Figs. 1A to 1D.

First, as shown in Fig. 1A, a negative-working type EB resist layer 12 is formed on a substrate 11. The substrate 11, as shown, has the topographic feature, i.e., a stepped portion. Then, as shown in Fig. 1B, an electrically discharging layer 13 is coated over the resist layer 12. The discharging layer 13 can be formed by spin coating from a solution of the polymer of the present invention. After the formation of the discharging layer 13, as shown in Fig. 1C, the resist layer 12 is irradiated, through the discharging layer 13, with a pattern of electron beams ($e^-$), and as a result of this EB patterning, an exposed area 14 of the resist layer is cross-linked, and therefore, becomes insoluble to a developer used in the subsequent development step. Note, because of the presence of the discharging layer 13, an accumulation of the electrical charge in the resist layer 12 can be effectively prevented.

The pattern-wise exposed resist layer is then developed with the developer to remove an unexposed resist layer and an overcoated discharging layer. As shown in Fig. 1D, a fine EB resist pattern 14 not having a misaligned pattern is obtained. The resist pattern 14 is used as a mask, when the substrate 11 is etched.

The pattern formation process using the bi-level resist process can be carried out, for example, as shown in Figs. 2A to 2F.

First, as shown in Fig. 2A, a bottom layer resist or planarizing layer 22 (also serving as an electrically discharging layer) is formed on a substrate 21 from the electrical discharging polymer of the present invention. The substrate 21 has a topographic feature. Next, as shown in Fig. 2B, a top layer resist or EB resist layer 23 of negative-working type is coated over the bottom layer resist 22 to complete a bi-level resist structure. The EB resist layer 23 is thinner than the layer 22. Thereafter, the top layer resist 23 is irradiated with a pattern of electron beams ($e^-$), as shown in Fig. 2C. The electron beams are not distorted because of the presence of the discharging layer of the present invention, and as shown, an exposed area 24 of the top layer resist is made insoluble to an developer due to a cross-linking of the EB resist. After completion of the EB patterning, the exposed top layer resist is developed with the developer to remove only the unexposed areas thereof, as shown in Fig. 2D, and following the patterning of the top layer resist, as shown in Fig. 2E, the pattern 24 of the top layer resist is transferred to the underlying bottom layer resist 22 by dry etching the resist 22 through the patterned resist 24 as a mask. The resulting pattern 22 of the bottom layer resist is not being misaligned, as shown in Fig. 2F.

Although not shown, the pattern formation using the positive-working resists in the processes of Figs. 1A to 1D and Figs. 2A to 2F will be easily understood to a person skilled in the art.

The present invention will be further described with reference to the following working examples and comparative examples.

Example 1:

A 15% solution of poly 3,4-diphenylbutadiene in xylene was spin-coated on a silicon substrate or wafer, and baked at 100°C for 20 minutes to form a bottom layer resist having a thickness of 2 μm. Thereafter, a solution of the silicon-containing resist, "SNR" commercially available from Tosoh Co. was spin-coated on the bottom layer resist to form a top layer resist having a thickness of 0.2 μm. A bi-level resist structure was thus obtained.

Next, the bi-level resist structure was evaluated with regard to the misalignment, i.e., shift level, of the resist patterns obtained after the EB patterning thereof. The top layer resist was exposed to a predetermined EB patterning at 25 $\mu C/cm^2$ and an accelerated voltage of 30 KeV, developed with methyl isobutyl ketone (MIBK), and rinsed in isopropyl alcohol (IPA). Measurements of the resulting EB resist patterns idicated that the shift level of the patterns was 0.15 μm (acceptable).

Example 2:

The procedure of Example 1 was repeated, with the proviso that poly phenylacetylene was used in place of poly 3,4-diphenylbutadiene, and a 22% solution of poly phenylacetylene in xylene was spin-coated on the silicon substrate, and baked at 100°C for 20 minutes. Measurements of the resulting EB resist patterns indicated that the shift level of the patterns was 0.18 μm (acceptable).

Example 3:

The procedure of Example 1 was repeated, with the proviso that poly α-methylstyrene was used in place of poly 3,4-diphenylbutadiene, and a 18% solution of poly α-methylstyrene in monochlorobenzene was spin-coated on the silicon substrate and baked at 100°C for 20 minutes. Measurements of the resulting EB resist patterns indicated that the shift level of the patterns was 0.18 μm (acceptable).

Example 4:

The procedure of Example 1 was repeated, with the proviso that poly chloroprene was used in place of poly 3,4-diphenylbutadiene, and a 15% solution of poly chloroprene in xylene was spin-coated on the silicon substrate and baked at 100°C for 20 minutes. Measurements of the resulting EB resist patterns indicated that the shift level of the patterns was 0.10 μm (acceptable).

Example 5:

The procedure of Example 1 was repeated, with the proviso that poly chlorophenylacetylene was used in place of poly 3,4-diphenylbutadiene, and a 15% solution of poly chlorophenylacetylene in xylene was spin-coated on the silicon substrate and baked at 100°C for 20 minutes. Measurements of the resulting EB resist patterns indicated that the shift level of the patterns was 0.15 μm(acceptable).

Comparative Example 1:

The procedure of Example 1 was repeated with the proviso that, for comparative purposes, the commercially available positive resist: "OFPR" of Tokyo Ohka Co. consisting of phenol-novolak resin was used in place of poly 3,4-diphenylbutadiene, and a solution of the resist was spin-coated on the silicon substrate and baked at 180°C for 20 minutes. Measurements of the resulting EB resist patterns indicated that the shift level of the patterns was 0.35 μm (unacceptable).

Example 6:

A resist solution of poly methylmethacrylate (PMMA): "OEBR" of Tokyo Ohka Co. was spun-coated at a thickness of 2 μm on a silican substrate, baked at 180°C for 20 minutes, and then dried to form a single layer resist. After formation of the single layer resist, a 10% solution of poly chloroprene in xylene was spin-coated over the previously formed resist coating, and heated and dried at 100°C to form a discharging layer of the present invention having a thickness of 500 Å.

Next, to evaluate the misalignment, i.e., shift level, of the resist patterns obtained after EB patterning of the resist coating from those before EB patterning the positions of alignment marks on four corners of the chip were measured. After this measurement, the resist coating was exposed to a predetermined EB patterning at 25 $\mu C/cm^2$ and an accelerated voltage of 30 KeV. The exposure area was 20% of the total area of the chip. The exposed resist coating was developed with MIBK, and rinsed in IPA. After rinsing, the positions of the alignment marks of the chip were again measured, to compare the positions of the alignment marks before and after the EB exposure and thereby determine the shift level of the patterns. The results of the comparison indicated that the shift level of the patterns was 0.05 μm (acceptable).

Examples 7 to 10:

The procedure of Example 6 was repeated, with the proviso that the polymer solution described in the following Table 1 was used in place of the 10% xylene solution of poly chloroprene. The results are also described in the following Table 1.

Table 1

| Example No. | Polymer solution | Shift level (μm) |
|---|---|---|
| 7 | 5% solution of poly 3,4-diphenylbutadiene in xylene | 0.15 to 0.20 |
| 8 | 9% solution of poly phenylacetylene in xylene | 0.20 |
| 9 | 7% solution of poly α-methylstyrene in monochlorobenzene | 0.10 to 0.15 |
| 10 | 2% solution of poly chlorophenylacetylene in xylene | 0.15 |

The above results indicate that the shift level of the patterns obtained in these examples was acceptable.

Comparative Example 2:

The procedure of Example 6 was repeated with the proviso that, for comparative purposes, a 10% solution of poly chloroprene in xylene was not overcoated over the PMMA resist coating. The results of the comparison of the positions of the alignment marks before and after EB exposure indicated that the shift level of the patterns was 0.45 μm (unacceptable).

**Claims**

1. A process for the formation of resist patterns which comprises the steps of:
   forming a layer of electron beam-sensitive resist on the substrate, with the proviso that, before or after the formation of this layer, an electron beam-insensitive polymer selected from the group consisting of diene polymers, acetylene polymers and aklylstyrene polymers is applied to the substrate to form a combination of the electron beam-sensitive resist layer and the electrically discharging polymer layer adjacent thereto;
   pattern-wise exposing the electron beam-sensitive resist layer to an electron beam; and
   developing the pattern-wise exposed resist layer to selectively remove the exposed or unexposed area of the resist layer.

2. A process according to claim 1, in which the diene polymer is poly 3,4-diphenylbutadiene or poly chloroprene.

3. A process according to claim 1, in which the acetylene polymer is poly phenylacetylene or poly chorophenylacetylene.

4. A process according to claim 1, in which the aklylstyrene polymer is poly α-methylstyrene.

5. A process according to claim 1, in which the electrically discharging polymer layer is formed as an overcoat

layer over the electron beam-sensitive resist layer of a single layer structure.

6. A process according to claim 5, which comprises the steps of:
forming a layer of the electron beam-sensitive resist on the substrate:
further forming a layer of the electrically discharging polymer over the electron beam-sensitive resist layer,
pattern-wise exposing the electron beam-sensitive resist layer through the electrically discharging polymer layer to the electron beam; and
developing the exposed resist layer with a developer.

7. A process according to claim 1, in which the electrically discharging polymer layer is used as a bottom layer resist in a bi-level resist structure.

8. A process according to claim 7, which comprises the steps of:
forming a layer of the electrically discharging polymer as a bottom layer resist on the substrate;
further forming a layer of the electron beam-sensitive resist as a top layer resist over the electrically discharging polymer layer;
pattern-wise exposing the electron beam-sensitive resist layer to the electron beam;
developing the exposed resist layer with a developer; and
dry etching the electrically discharging polymer layer through the developed resist layer as a mask to thereby transfer a pattern of the resist layer to the electrically discharging polymer layer.

9. A process according to claim 1, which is used in the production of semiconductor devices.

10. A process according to claim 9, in which the substrate is etched through the patterned resist layer as a mask to form a part of the semiconductor devices.

Fig. 1A

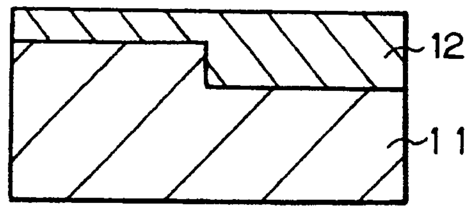


Fig. 1B

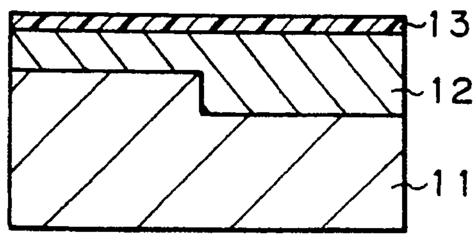


Fig. 1C

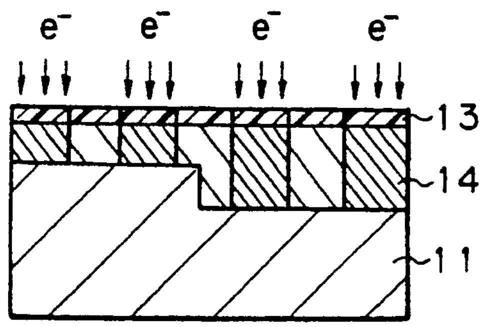


Fig. 1D

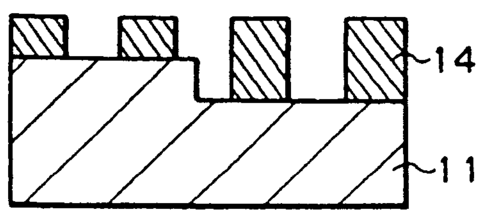

Fig. 2A

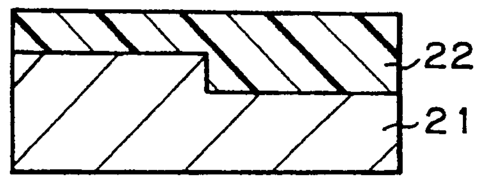


Fig. 2B

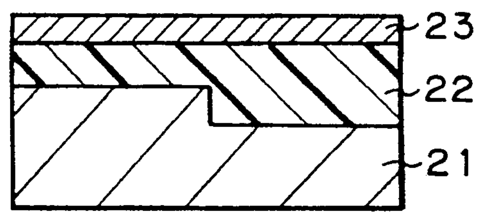


Fig. 2C

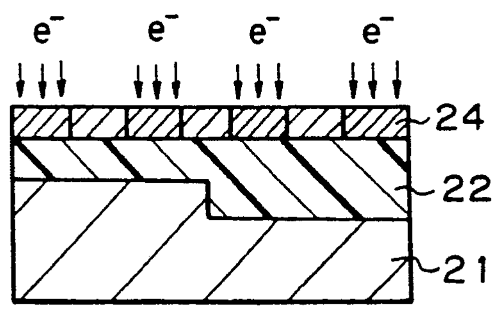

Fig. 2D

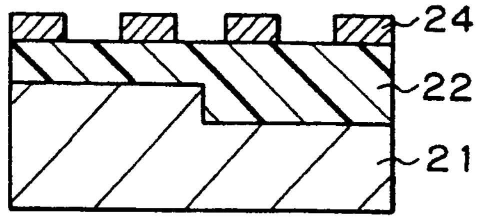


Fig. 2E

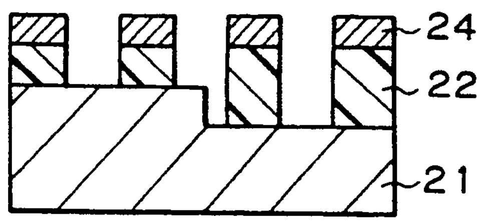


Fig. 2F

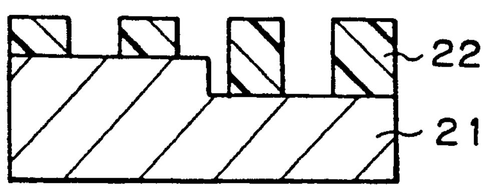

European Patent Office

# EUROPEAN SEARCH REPORT

Application Number

EP 91 30 1866

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 348 961 (MATSUSHITA)<br>* claims; abstract; page 9, lines 20-51 *<br>--- | 1-10 | G 03 F 7/11 |
| A | EP-A-0 315 375 (FUJITSU)<br>* page 9, lines 2-50; claim 1 *<br>--- | 1-10 | |
| A | EP-A-0 054 683 (BASF)<br>* claims 1,2; page 2, lines 11-36 *<br>--- | 1-10 | |
| A | PATENT ABSTRACTS OF JAPAN vol. 11, no. 366 (P-641)(2813), 28 November 1987; & JP - A - 62139547 (DAICEL) 23.06.1987<br>--- | 1-10 | |
| A | US-A-3 894 163 (B. BROYDE)<br>* whole document *<br>--- | 1-4 | |
| A | US-A-4 702 993 (L. WHITE et al.)<br>* whole document *<br>----- | 1 | |
| | | | TECHNICAL FIELDS SEARCHED (Int. Cl.5) |
| | | | G 03 F |

The present search report has been drawn up for all claims

| Place of search | Date of completion of the search | Examiner |
|---|---|---|
| BERLIN | 21-06-1991 | STOCK H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)